# EUROPEAN PATENT APPLICATION

(11) **EP 2 009 703 A1**
(43) Date of publication of application: **31.12.2008**
(21) Application number: 07740989.4
(22) Date of filing: 04.04.2007
(51) Int. Cl.: H01L 31/04

(54) **SOLAR CELL, SOLAR CELL MODULE USING THE SOLAR CELL AND METHOD FOR MANUFACTURING THE SOLAR CELL MODULE**

(30) Priority: 14.04.2006 JP 2006112409
(71) Applicant: Sharp Kabushiki Kaisha, Osaka 545-8522 (JP)
(72) Inventor: YOSHIDA, Atsushi, Nara 639-1103 (JP); JUSO, Hiroyuki, Nara 639-0223 (JP); TAKAMOTO, Tatsuya, Nara 636-0821 (JP)
(74) Representative: Müller - Hoffmann & Partner
(86) International application number: PCT/JP2007/057553
(87) International publication number: WO 2007/119673

(57) **Abstract**

In a solar cell, a body portion that includes at least one PN junction portion that is formed by laminating a P layer and an N layer in the front to back direction is formed. End faces of the PN junction portion form part of side faces of the body portion, and a surface electrode is formed on a surface of the body portion and a back surface electrode is formed on a back surface of the body portion. The surface electrode includes a terminal attachment portion to which a surface electrode connecting lead wire through which an electromotive force is extracted is bonded by wire-bonding or spot-welding. An anti-reflection film is formed on a surface of the surface electrode that includes the terminal attachment portion and the surface of the body portion other than a portion where the surface electrode is formed.

## Description

### Technical Field

The present invention relates to a solar cell, a solar cell module in which such a solar cell is used, and a method for manufacturing such a solar cell module.

### Background Art

A solar cell is a device for converting sunlight into electricity that is configured by forming a PN junction with compound semiconductors on a substrate. In order to efficiently utilize sunlight, normally, an anti-reflection film for preventing sunlight from being reflected by the surface of the solar cell is formed on the surface of the solar cell such that the anti-reflection film covers the surface of the solar cell. In the solar cell, a surface electrode through which the output of the solar cell is extracted is formed on the surface of the solar cell, and a back surface electrode is formed on the back surface of the solar cell.

As just mentioned, the surface electrode formed on the surface of the solar cell is used to extract the output of the solar cell. For this reason, a surface electrode connecting lead wire is connected to the surface electrode. In order to connect the surface electrode connecting lead wire to the surface electrode, in conventional solar cells, the surface electrode is not covered with the anti-reflection film or the like and thus is exposed to the outside (see, for example, FIG. 2 of Patent Document 1).

As such, conventional solar cells have a configuration in which a surface electrode exposed to the outside is formed on the surface of the solar cell, and an anti-reflection film for covering the surface is formed on the surface of the solar cell other than the portion where the surface electrode is formed.

As the method for realizing the above configuration, the following methods have conventionally been used. First, a surface electrode is formed on the surface of a solar cell. After that, the surface electrode portion is covered with a photoresist by photolithography. Then, an anti-reflection film is formed on the surface of the solar cell such that the anti-reflection film also covers the surface electrode. After that, the photoresist is removed so as to expose the surface electrode. This is called lift-off method. Another method is to form an anti-reflection film on the entire surface of a solar cell after a surface electrode is formed on the surface of the solar cell, cover a region other than the surface electrode portion with a photoresist by photolithography, and remove the anti-reflection film of the surface electrode portion by etching to expose the surface electrode.

On the other hand, previously, a light-concentrating solar cell module in which a solar cell as described above is used has been proposed (see, for example, Patent Document 2). A light-concentrating solar cell module of the related art includes, for example, a non-imaging Fresnel lens that is fitted to the opening face of a case having an opening at the upper surface thereof, and a solar cell support plate that is disposed on the bottom face of the case so as to face the non-imaging Fresnel lens. The solar cell as described above is held on the solar cell support plate with the surface of the solar cell facing upward.

The light-concentrating solar cell module described above has a concentration magnification of several ten to several hundred times, and so the temperature of the solar cell rises due to the concentrated sunlight. Because the power generation efficiency lowers as the temperature rises, the solar cell needs to dissipate heat. For this purpose, the solar cell support plate used in the light-concentrating solar cell module is made with a material having a large heat conductivity, such as a metal, and the solar cell is bonded to the solar cell support plate so that heat is dissipated through the back surface of the solar cell.

As a method of holding the solar cell on the solar cell support plate, the light-concentrating solar cell module according to Patent Document 2 employs the following method. In the light-concentrating solar cell module of Patent Document 2, the functions of a back surface electrode and a back surface electrode connecting lead wire are realized by using a metal foil. And, a method is used in which the metal foil is soldered to the entire back surface of the substrate of the solar cell, and the metal foil is bonded to the solar cell support plate (base plate) with an adhesive (heat dissipating layer) such as an epoxy resin adhesive containing a heat conductive filler.

Because a very thin metal foil is used in this method, the occurrence of stress caused by a difference in thermal expansion coefficient between the substrate of the solar cell and the metal foil when the substrate and the metal foil are soldered can be reduced, and at the same time, heat from the solar cell is sufficiently dissipated through the metal foil, the heat dissipating layer and the base plate. In addition, because an epoxy resin is used for bonding, it is advantageous in securing durability and long term reliability.
[Patent Document 1] JP 2002-141546A
[Patent Document 2] JP 2003-174179A

### Disclosure of Invention

### Problems to be Solved by the Invention

However, in the case of the aforesaid solar cell of the related art that is configured such that the surface electrode is exposed to the outside, it is necessary to perform a work process that employs the above-described lift-off method or etching as a step of forming an anti-reflection film for covering the surface of the solar cell and further forming the surface electrode exposed to the outside.

This work process requires a complicated task such as photolithography or a task for exposing the surface electrode, resulting in a problem of poor production efficiency. Furthermore, the addition of the work process causes a problem of low yield. In addition, in this work process, the accuracy of photolithography may not be secured sufficiently. If this happens, the anti-reflection film is not formed sufficiently on the light-receiving face, and as a result, a solar cell produced by the above method may have low conversion efficiency.

Furthermore, in the above-described light-concentrating solar cell module of the related art in which the aforesaid solar cell is used, it is necessary to use a sufficient amount of solder to bond the metal foil to the entire back surface of the substrate of the solar cell, and also to apply pressure on the solar cell to press it against the solar cell support plate when soldering. During this process, a problem occurs in that the solder may protrude from the back surface of the solar cell and adhere to a side face of the solar cell or the surface electrode due to surface tension, and a leak current flows in the solar cell when in use. This problem occurs not only in the solar cell using a metal foil as described above, but also in a conventional solar cell that includes a back surface electrode on the back surface thereof when bonding the back surface electrode to a solar cell support plate using a conductive paste.

In view of the above, the present invention has been conceived to solve the above problems, and it is an object of the present invention to provide a solar cell that does not require a step that involves a complicated task used to expose a surface electrode formed on the surface of the solar cell in the manufacture of the solar cell, a solar cell module in which a leak current does not flow in the solar cell when in use due to defects caused during the manufacture, and a method for manufacturing such a solar cell module.

### Means for solving the Problems

A solar cell according to the present invention will be described first. A solar cell according to the present invention is a solar cell, wherein a body portion that includes at least one PN junction portion formed by laminating a P layer and an N layer in the front to back direction is formed, end faces of the PN junction portion form part of side faces of the body portion, and a surface electrode is formed on a surface of the body portion and a back surface electrode is formed on a back surface of the body portion, the surface electrode includes a terminal attachment portion to which a surface electrode connecting lead wire through which an electromotive force is extracted is bonded by wire-bonding or spot-welding, and an anti-reflection film is formed on a surface of the surface electrode that includes the terminal attachment portion and the surface of the body portion other than a portion where the surface electrode is formed. For example, in this solar cell, by wire-bonding or spot-welding the surface electrode connecting lead wire through which an electromotive force is extracted, the anti-reflection film covering the surface of the surface electrode is broken, and the surface electrode is connected to the surface electrode connecting lead wire. Through this, the surface electrode can be connected to the surface electrode connecting lead wire.

In the aforesaid solar cell according to the present invention, the surface electrode of the solar cell is covered with the anti-reflection film, but the surface electrode connecting lead wire can be connected to the surface electrode by wire-bonding or spot-welding. Accordingly, because the surface electrode of the solar cell can be kept covered with the anti-reflection film, the above-described step of exposing the surface electrode that involves a complicated task can be eliminated from the manufacture of the solar cell.

In the above configuration, the anti-reflection film may be formed on side faces of the surface electrode so as to cover the side faces. Furthermore, in this configuration, it is preferable that the side faces of the surface electrode are inclined to taper from the surface of the body portion toward the surface of the surface electrode. With this configuration, the anti-reflection film can be formed easily and reliably on the side faces of the surface electrode when manufacturing the solar cell as compared to the case where the side faces of the surface electrode are not inclined to taper from the surface of the body portion toward the surface of the surface electrode.

In the aforesaid solar cell, it is preferable that the anti-reflection film formed on the surface (and side faces) of the surface electrode and the surface of the body portion other than a portion where the surface electrode is formed has an insulating property. The reason for this will be described later.

In the above configuration, the anti-reflection film may be formed on predetermined side faces that are at least part of the side faces of the body portion extending from the surface of the body portion and include the end faces of the PN junction portion so as to cover the predetermined side faces. Furthermore, in this configuration, it is preferable that the predetermined side faces are inclined to taper from the back surface toward the surface of the body portion. With this configuration, the anti-reflection film can be formed easily and reliably on the predetermined side faces of the body portion when manufacturing the solar cell as compared to the case where the predetermined side faces are not inclined to taper from the back surface toward the surface of the body portion.

Also, it is preferable that the anti-reflection film has an insulating property. This is because the following efficacy and effect can be achieved when both the anti-reflection film covering the predetermined side faces of the body portion and the anti-reflection film formed on the surface (and side faces) of the surface electrode of the solar cell and the surface of the body portion other than a portion where the surface electrode is formed have an insulating property.

In the aforesaid solar cell, the body portion that includes at least one PN junction portion that is formed by laminating a P layer and an N layer in the front to back direction is formed, and the end faces of the PN junction portion form the predetermined side faces that are part of the side faces of the body portion. If it is assumed that the anti-reflection film having an insulating property is not formed on the predetermined side faces, the following event is conceived to occur.

That is, if such a solar cell is used in a solar cell module described later, when the solar cell is fixed to a solar cell holding plate with a conductive paste to manufacture the solar cell module, which will be described later, the conductive paste bonding to the back surface electrode of the solar cell may adhere to a predetermined side face of the body portion of the solar cell. In this case, if the conductive paste adheres to a predetermined side face of the body portion of the solar cell, that is, the conductive paste bonding to the back surface electrode of the solar cell adheres to the end face of the PN junction portion, a drawback will occur that a leak current flows in the solar cell when in use. This drawback occurs similarly when the anti-reflection film covering the predetermined side faces of the body portion of the solar cell does not have an insulating property.

In the aforesaid solar cell, when the anti-reflection film that is formed to cover the surface (and side faces) of the surface electrode of the solar cell does not have an insulating property, and this solar cell is used in a solar cell module described later, the same event as described above is considered to occur. Specifically, when the solar cell is fixed to a solar cell holding plate with a conductive paste to manufacture the solar cell module, the conductive paste bonding to the back surface electrode of the solar cell may adhere to the surface electrode of the solar cell. In this case, as in the above-described case, the drawback will occur that a leak current flows in the solar cell when in use.

However, when the anti-reflection film having an insulating property is formed on the surface (and side faces) of the surface electrode of the solar cell, the surface of the body portion other than a portion where the surface electrode is formed, and the predetermined side faces of the body portion so as to cover these faces as described above, even if the conductive paste for fixing the solar cell to the solar cell holding plate adheres to the surface electrode of the solar cell during manufacture of a solar cell module using the solar cell, it is possible to prevent a leak current from flowing in the solar cell when in use.

A solar cell module of the present invention will be described. A solar cell module according to the present invention includes: the above-described solar cell; a solar cell holding plate that is made of metal and holds the solar cell; and the surface electrode connecting lead wire through which an electromotive force is extracted, wherein the surface electrode connecting lead wire is connected to the terminal attachment portion by wire-bonding or spot-welding, the anti-reflection film has an insulating property, and at least the surface of the surface electrode other than a portion where the surface electrode connecting lead wire is connected to the surface electrode of the solar cell and the surface of the body portion other than a portion where the surface electrode is formed are covered with the anti-reflection film, and a conductive paste layer is formed between the back surface electrode of the solar cell and the solar cell holding plate, and the solar cell is held by the solar cell holding plate with the back surface electrode of the solar cell being fixed to the solar cell holding plate by the conductive paste layer.

According to this solar cell module, even if the conductive paste for fixing the solar cell to the solar cell holding plate adheres to the surface electrode of the solar cell or a predetermined side face of the body portion when manufacturing the solar cell module, it is possible to prevent a leak current from flowing in the solar cell when in use.

A method for manufacturing a solar cell module according to the present invention will be described. A method for manufacturing a solar cell module according to the present invention is a method for manufacturing the aforesaid solar cell module.

The method for manufacturing a solar cell module includes the steps of: forming the conductive paste layer between the back surface electrode of the solar cell and the solar cell holding plate; and fixing the solar cell to the solar cell holding plate by pressing the solar cell against the solar cell holding plate such that the back surface electrode of the solar cell comes close to the solar cell holding plate.

Specifically, according to the method for manufacturing a solar cell module, the conductive paste layer is formed between the back surface electrode of the solar cell and the solar cell holding plate, and at the same time, the solar cell is fixed to the solar cell holding plate by pressing the solar cell against the solar cell holding plate such that the back surface electrode of the solar cell comes close to the solar cell holding plate while the conductive paste is allowed to protrude from the conductive paste layer over a predetermined side face of the body portion of the solar cell or the predetermined side face of the body portion of the solar cell and the surface electrode of the solar cell.

The expression "the conductive paste is allowed to protrude" used when describing the method for manufacturing a solar cell means that the conductive paste may protrude, and it does not mean that the conductive paste has to protrude.

The method for manufacturing a solar cell module has effects similar to those described in the solar cell module above.

In the aforesaid method for manufacturing a solar cell module, it is preferable to connect the surface electrode connecting lead wire to the surface electrode of the solar cell by wire-bonding or spot-welding. That is, although the surface electrode of the solar cell used in the method for manufacturing a solar cell module is covered with the anti-reflection film, the surface electrode connecting lead wire can still be connected to the surface electrode by wire-bonding or spot-welding. Therefore, according to the method for manufacturing a solar cell module, because it is unnecessary to use a cost and time consuming conventional solar cell which requires the step of exposing the surface electrode that involves a complicated task as described above, it is possible to achieve cost reduction.

### Effects of the Invention

In the solar cell according to the present invention, the surface electrode of the solar cell is covered with the anti-reflection film, but the surface electrode connecting lead wire can be connected to the surface electrode by wire-bonding or spot-welding. Accordingly, because the surface electrode of the solar cell can be kept covered with the anti-reflection film, the step of exposing the surface electrode that involves a complicated task as described above can be eliminated from the manufacture of the solar cell.

Furthermore, because the side faces of the surface electrode are inclined to taper from the surface of the body portion toward the surface of the surface electrode, and the predetermined side faces of the body portion are inclined to taper from the back surface toward the surface of the body portion, the anti-reflection film can be formed easily and reliably on the side faces of the surface electrode and the predetermined side faces of the body portion as compared to the case where the side faces and the predetermined side faces are not inclined.

In the solar cell used in the solar cell module of the present invention, the anti-reflection film having an insulating property is formed on the surface and side faces of the surface electrode of the solar cell, the surface of the body portion other than a portion where the surface electrode is formed, and the predetermined side faces of the body portion so as to cover these faces. Accordingly, even if the conductive paste for fixing the solar cell to the solar cell holding plate adheres to the surface electrode of the solar cell or a predetermined side face of the body portion when manufacturing the solar cell module, it is possible to prevent a leak current from flowing in the solar cell when in use.

According to the method for manufacturing a solar cell module of the present invention, although the surface electrode of the solar cell used in the method for manufacturing a solar cell module is covered with the anti-reflection film, the surface electrode connecting lead wire still can be connected to the front surface electrode by wire-bonding or spot-welding. Therefore, according to the method for manufacturing a solar cell module, because it is unnecessary to use a cost and time consuming conventional solar cell which requires the step of exposing the surface electrode that involves a complicated task as described above, it is possible to achieve a reduction in manufacturing cost of the solar cell module.

### Brief Description of Drawings

[FIG. 1] FIG. 1 is a cross-sectional view of a solar cell according to Embodiment 1.
[FIG. 2] FIG. 2 is a cross-sectional view of a solar cell according to Embodiment 2.
[FIG. 3] FIG. 3 is a cross-sectional view of a solar cell according to Embodiment 3.
[FIG. 4] FIG. 4 is a cross-sectional view of a solar cell according to Embodiment 4.
[FIG. 5] FIG. 5 is a cross-sectional view of another example of a solar cell according to Embodiment 4.
[FIG. 6] FIG. 6 is a cross-sectional view of a solar cell module according to Embodiment 5.
[FIG. 7] FIG. 7 is an enlarged cross-sectional view of an attachment portion of the solar cell of the solar cell module according to Embodiment 5.

### Description of Reference Numerals

- 1: Substrate
- 2: Base Layer
- 3: Emitter Layer
- 4: Window Layer
- 5: Contact Layer
- 6: Surface Electrode
- 7: Back Surface Electrode
- 8: PN Junction Portion
- 9: Predetermined Side Face
- 10: Anti-Reflection Film
- 11: Surface Electrode Portion
- 12: Body Portion
- 21: Solar Cell
- 22: Solar Cell
- 23: Solar Cell
- 24: Solar Cell
- 31: Solar Cell Module
- 32: Case
- 32a: Solar Cell Holding Plate Support Portion
- 33: Fresnel Lens
- 34: Surface Electrode Connecting Lead Wire
- 35: Solar Cell Holding Plate
- 36: Conductive Paste
- 37: Adhesive
- 38: Sunlight
- 39: Irradiation Light

### Best Mode for Carrying Out the Invention

### <Embodiment 1>

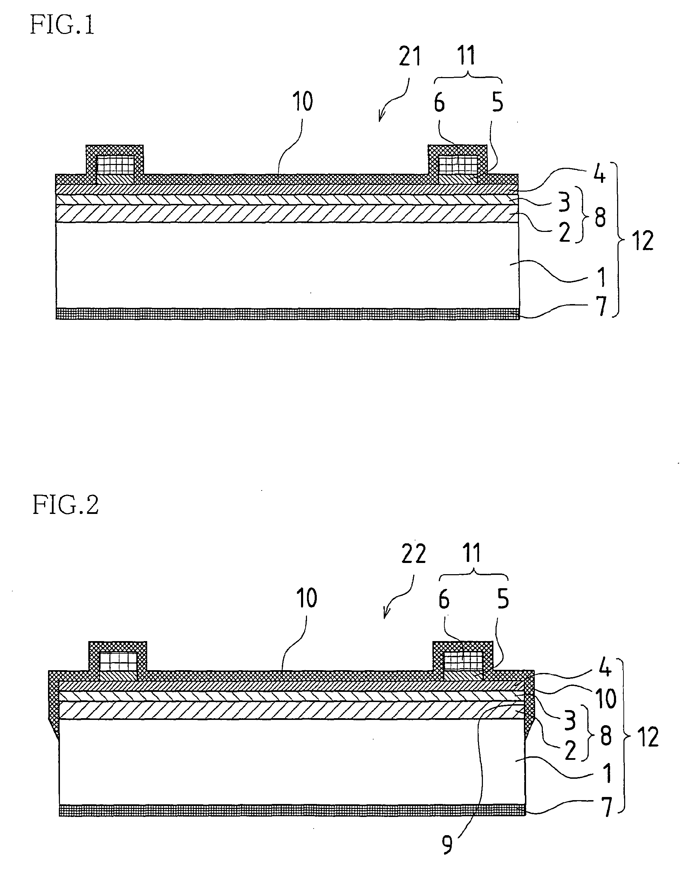

Hereinafter, a solar cell according to an embodiment of the present invention will be described with reference to the accompanying drawings. FIG. 1 is a cross-sectional view of a solar cell 21 according to Embodiment 1. As shown in FIG. 1, the solar cell 21 according to Embodiment 1 is configured of surface electrode portions 11 and a body portion 12. An anti-reflection film 10 is formed on the surface and side faces of each surface electrode portion 11 and the surface of the body portion 12 other than the portions where the surface electrode portions 11 are formed so as to cover these faces. In other words, the surface and side faces of the surface electrode portions 11 are entirely covered with the anti-reflection film 10, and so the surface and side faces of the surface electrode portions 11 are not exposed to the outside, unlike the surface electrode of the solar cell of the related art described above.

In the body portion 12, a back surface electrode 7 is formed on the back surface, that is, the lower surface, of a horizontally disposed plate-like substrate 1. On the surface, that is, the upper surface, of the substrate 1, a base layer 2, an emitter layer 3 and a window layer 4 that are made of compound semiconductors are laminated in this order from the surface upward in the vertical direction, that is, the front to back direction. The base layer 2 serves as a P layer described above, and the emitter layer 3 serves as an N layer described above. The base layer 2 and the emitter layer 3 together form a PN junction portion 8.

A surface electrode portion 11 is configured of a contact layer 5 that is formed on the window layer 4 serving as the surface layer of the body portion 12 and a surface electrode 6 that is formed on the contact layer 5. As for the surface electrode 6, because all of the surface and side faces of the surface electrode portion 11 are covered with the anti-reflection film 10 as described above, all of the surface and side faces of the surface electrode 6 are covered with the anti-reflection film 10.

As the material for the substrate 1 constituting the body portion 12, Ge, GaP, GaAs or the like is used. This substrate 1 has a thickness typically used for substrates for solar cells. As the substrate 1, it is also possible to use a substrate in which a pn junction is formed near the substrate surface (the surface on which compound semiconductor layers are formed).

As the material for the base layer 2, GaAs, InGaAs or the like is used. As the material for the emitter layer 3, AlGaAs, InGaAs, InGaP, AlInGaP or the like is used. As the material for the window layer 4, InGaP, AlGaAs or the like is used.

The solar cell 21 according to Embodiment 1 employs a three-layer structure that is formed of the base layer 2, the emitter layer 3 and the window layer 4 as the layer structure formed of compound semiconductors. But the present embodiment is not limited thereto, and it is also possible to use a layer structure other than the three-layer structure such as a two-layer structure, a four-layer structure or a layer structure that includes more layers. Furthermore, it is also possible to include, in addition to the base layer and the emitter layer, compound semiconductor layers such as a buffer layer, a BSF (Back Surface Field) layer, the tunnel junction layer of a multijunction photoelectric conversion element, and another base layer or emitter layer of the multijunction photoelectric conversion element.

The contact layer 5 constituting the surface electrode portion 11 is a compound semiconductor layer for ohmic contact that is formed on the uppermost layer of the aforementioned compound semiconductor layers. As the material for the contact layer 5, GaAs, InGaAs or the like is used.

As the material for the surface electrode 6 that is an ohmic electrode, Au-Ge/Ni/Au, Ti/Pd/Ag or the like is used. Similarly, as the material for the back surface electrode 7 that is an ohmic electrode, Au, Au/Ag or the like is used.

As the material for the anti-reflection film 10, a highly insulating material, such as SiO, SiN or TiO₃/Al₂O₃, is used. Typically, as the material for the anti-reflection film 10, ZnS, ZnS/MgF₂ or the like is used. These materials, however, have a low insulating property as compared to the materials listed above, and thus are not used in the solar cell 21 of Embodiment 1.

A method for manufacturing the solar cell 21 of Embodiment 1 will be described next. The method for manufacturing the aforesaid solar cell 21 involves step 1 to step 8, and steps 1 to 8 are sequentially performed. In step 1, first, the base layer 2, the emitter layer 3, the window layer 4 and the contact layer 5 are laminated in this order on the substrate 1 by MOCVD method (metal-organic chemical vapor deposition method) or the like. For example, a p-type GaAs base layer 2, an n+ type GaAs emitter layer 3, an n+InGaP window layer 4 and an n+ type GaAs contact layer 5 are epitaxially grown on a p+ type GaAs substrate 1 having a thickness of approximately 200 µm in a successive manner with a substrate temperature of approximately 650 to 700°C. As the source gas used for the epitaxial growth, TEG (trimethylgallium), TMI (trimethylindium), AsH₃ (arsine), PH₃ (phosphine) or the like is used. As the n-type dopant gas, SiH₄ (monosilane) or the like is used. As the p-type dopant gas, DEZn (diethyl zinc) or the like is used.

Next, in step 2, a resist is applied onto the surface of the laminated compound semiconductor layers, a pattern for the surface electrode 6 is formed by photolithography method, and a metal film that will serve as the surface electrode 6 is formed on the pattern by vacuum deposition. Specifically, approximately 100 nm thick Au-Ge (12wt%) is formed by resistance heating deposition method, and then an approximately 20 nm thick Ni layer and an approximately 3000 nm thick Au layer are formed by EB deposition method. After that, the surface electrode 6 that has a predetermined pattern is formed by lift-off method.

Subsequently, in step 3, the surface electrode 6 is sintered in an inert gas atmosphere, such as N₂, at 300 to 450°C. Next, in step 4, the surface electrode 6 is covered with a mask, and the portions of the contact layer 5 where the mask is not formed are removed by etching. An aqueous solution of ammonia and hydrogen peroxide solution is used for the etching. Consequently, although the back surface electrode 7 is not formed yet, the surface electrode portions 11 are formed on the body portion 12, forming the solar cell's 21 shape.

Subsequently, in step 5, a mesa etching pattern is formed on the surface of the body portion 12 by photolithography, and the mesa etching portions of the compound semiconductor layers are removed by etching to expose the substrate 1. An aqueous bromine-based solution is used as an etching solution for the etching. Subsequently, the mesa etching pattern formed in the above step is cut into dice having a predetermined cell shape.

Next, in step 6, the back surface electrode 7 is formed on the back surface of the substrate 1. The back surface electrode 7 is formed by forming an approximately 1000 nm thick Au layer with EB deposition method.

Next, in step 7, the anti-reflection film 10 that has an insulating property is formed on the surface and side faces of the surface electrode portions 11 of the solar cell 21 and the surface of the body portion 12 other than the portions where the surface electrode portions 11 are formed. The anti-reflection film 10 is formed by forming a TiO₂ film and an Al₂O₃ film to have thicknesses of approximately 50 nm and approximately 85 nm, respectively, in this order by EB deposition method. The thickness of these films is set as appropriate, taking the refractive index of the films, the desired refractive index at the surface of the solar cell 21, and the like into account.

In the final step, step 8, the back surface electrode 7 and the anti-reflection film 10 are finally sintered in the same manner as in step 3, which completes the manufacture of the solar cell 21.

In the solar cell 21 according to Embodiment 1, a surface electrode connecting lead wire formed of aluminum, gold or the like needs to be connected to the surface electrode 6 of a surface electrode portion 11 to extract the output of the solar cell 21. The surface electrode connecting lead wire can be connected by performing wire-bonding or spot-welding on the anti-reflection film 10 covering the surface electrode 6 as will be described later. That is, the anti-reflection film 10 covering the surface of the surface electrode 6 is broken by wire-bonding or spot-welding, and the surface electrode connecting lead wire is bonded to the surface electrode 6.

In the aforesaid solar cell 21 according to Embodiment 1, the surface electrode portions 11 of the solar cell 21 are covered with the anti-reflection film 10, but the surface electrode connecting lead wire can be connected to the surface electrode 6 by wire-bonding or spot-welding. Because the surface electrode portions 11 of the solar cell can be kept covered with the anti-reflection film 10, the step of exposing the surface electrode that involves a complicated task as described above can be eliminated from the manufacture of the solar cell 21.

### <Embodiment 2>

FIG. 2 is a cross-sectional view of a solar cell 22 according to Embodiment 2. The solar cell 22 according to Embodiment 2 is almost the same as the solar cell 21 of Embodiment 1. The difference between the solar cell 22 of Embodiment 2 and the solar cell 21 of Embodiment 1 is that the anti-reflection film 10 having a high insulating property is formed also on the side faces of the body portion 12 so as to cover the side faces. Other than this, the solar cell 22 of Embodiment 2 is exactly the same as the solar cell 21 of Embodiment 1.

Specifically, the anti-reflection film 10 having an insulating property is formed on predetermined side faces 9 that are at least part of the side faces of the body portion 12 extending from the surface of the body portion 12 and include the end faces of the PN junction portion 8 so as to cover the predetermined side faces 9.

The solar cell 22 described above is manufactured as follows. Specifically, in step 7 of the method for manufacturing the solar cell 21 of Embodiment 1 in which the anti-reflection film 10 having an insulating property is formed on the surface and side faces of the surface electrode portions 11 of the solar cell 21 and the surface of the body portion 12 other than the portions where the surface electrode portions 11 are formed, the anti-reflection film 10 having an insulating property is formed also on the predetermined side faces 9 that are at least part of the side faces of the body portion 12 and include the end faces of the PN junction portion 8. Other steps are the same as those of the aforementioned method for manufacturing the solar cell 21 of Embodiment 1.

In step 7 described above, an anti-reflection film 10 formed of TiO₂/Al₂O₃ is formed by EB deposition, but it is also possible to use CVD method using SiO or SiN. In the case of CVD method, the anti-reflection film 10 can be formed simultaneously on the surface and side faces of the surface electrode portions 11 of the solar cell 21, the surface of the body portion 12 other than the portions where the surface electrode portions 11 are formed, and the side faces of the body portion 12.

With the solar cell 22 of Embodiment 2 described above, the following efficacy and effect can be obtained. Specifically, in the aforesaid solar cell 22, as described above, the body portion 12 including the PN junction portion 8 is formed, and the side faces of the PN junction portion 8 form the predetermined side faces 9 that are part of the side faces of the body portion 12. Furthermore, the anti-reflection film 10 having an insulating property is formed on the predetermined side faces 9 of the body portion 12 so as to cover the predetermined side faces 9, and at the same time, the anti-reflection film 10 having an insulating property is formed on the surface and side faces of the surface electrode portions 11 and the surface of the body portion 12 other than the portions where the surface electrode portions 11 are formed so as to cover these faces.

If it is assumed that the anti-reflection film 10 formed on the predetermined side faces 9, the surface and side faces of the surface electrode portions 11 and the surface of the body portion 12 other than the portions where the surface electrode portions 11 are formed does not have an insulting property, the following event is conceived to occur.

If such a solar cell 22 is used to manufacture a solar cell module described later, when the solar cell 22 is bonded to a solar cell holding plate with a conductive paste to manufacture the solar cell module, which will be described later, the conductive paste bonding to the back surface electrode 7 of the solar cell 22 may adhere to a surface electrode portion 11 of the solar cell 22, a predetermined side face 9 of the body portion, or both. In this case, if the conductive paste bonding to the back surface electrode 7 of the solar cell 22 adheres to any of these portions, a drawback will occur that a leak current flows in the solar cell 22. This drawback occurs also when the anti-reflection film 10 is not formed on the predetermined side faces 9 of the body portion 12 of the solar cell 22 to cover the predetermined side faces 9.

However, when the anti-reflection film 10 having an insulating property is formed on the front surface and side faces of the surface electrode portions 11 of the solar cell 22, the surface of the body portion 12 other than the portions where the surface electrode portions 11 are formed, and the predetermined side faces 9 of the body portion 12 so as to cover these faces as described above, even if the conductive paste that bonds to the solar cell 22 adheres to a surface electrode portion 11 of the solar cell 22 or a predetermined side face of the body portion 12 when manufacturing the solar cell module, it is possible to prevent a leak current from flowing in the solar cell 22.

In the solar cell 22 of Embodiment 2 described above, in the side faces of the body portion 12, the anti-reflection film 10 having an insulating property is formed only on the predetermined side faces 9 that are at least part of the side faces of the body portion 12 extending from the surface of the body portion 12 and include the end faces of the PN junction portion 8 so as to cover the predetermined side faces 9. However, the present embodiment is not limited thereto, and it is also possible to form the anti-reflection film 10 having an insulating property on the entire side faces of the body portion 12 so as to cover the entire side faces of the body portion 12.

### <Embodiment 3>

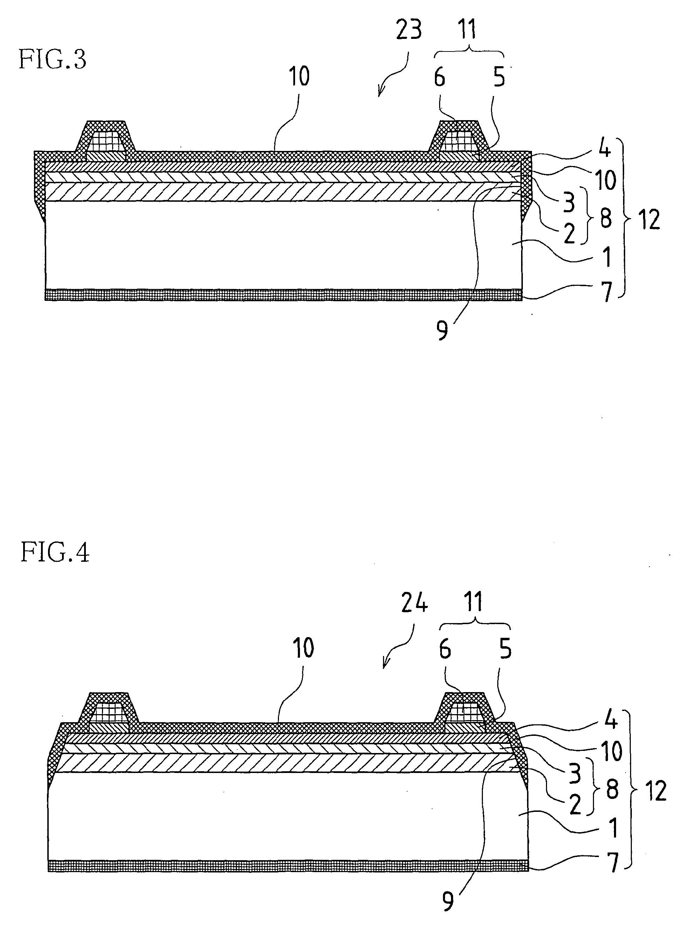

FIG. 3 is a cross-sectional view of a solar cell 23 according to Embodiment 3. The solar cell 23 according to Embodiment 3 is almost the same as the solar cell 22 of Embodiment 2. The only difference between the solar cell 23 of Embodiment 3 and the solar cell 22 of Embodiment 2 is the shape of the surface electrode portions 11. Other than this, the solar cell 23 of Embodiment 3 is exactly the same as the solar cell 22 of Embodiment 2. In the surface electrode portions 11 of the solar cell 23 of Embodiment 3 shown in FIG. 3, the side faces of the surface electrode 6 of each surface electrode portion 11 are inclined to taper from the surface of the body portion 12 toward the surface of the surface electrode 6.

The solar cell 23 described above is manufactured as follows. Step 2 of the method for manufacturing the solar cell 22 of Embodiment 2, that is, step 2 of the method for manufacturing the solar cell 21 of Embodiment 1, in which the surface electrode 6 is formed by lift-off method is changed as follows. Specifically, Au-Ge/Ni/Au is formed on the surface of the compound semiconductor layers that are formed through lamination in step 1. After that, an electrode pattern is formed on the metal film by photolithography, followed by etching using a metal etching solution such as a KI/I₂ solution, forming a surface electrode 6. With this method, the side faces of the surface electrode 6 can be inclined to taper from the surface of the body portion 12 toward the surface of the surface electrode 6. Other steps are the same as those of the aforementioned method for manufacturing the solar cell 22 of Embodiment 2.

In the solar cell 23 of Embodiment 3, the side faces of the surface electrode 6 have a shape in which the side faces are inclined to taper from the surface of the body portion 12 toward the surface of the surface electrode 6. Accordingly, the anti-reflection film 10 can be formed more easily and reliably on the side faces of the surface electrode 6, that is, the side faces of the surface electrode portions 11 when manufacturing the solar cell 23 as compared to the case where the side faces of the surface electrode 6 do not have that shape. Furthermore, when the side faces of the surface electrode 6 have the aforesaid inclined shape, the coverage of the anti-reflection film 10 covering the surface electrode 6 is improved, and it is therefore possible to obtain an increased effect of preventing a leak current from flowing in the solar cell 23.

### <Embodiment 4>

FIG. 4 is a cross-sectional view of a solar cell 24 according to Embodiment 4. The solar cell 24 according to Embodiment 4 is almost the same as the solar cell 23 of Embodiment 3. The only difference between the solar cell 24 of Embodiment 4 and the solar cell 23 of Embodiment 3 is the shape of the side faces of the body portion 12. Other than this, the solar cell 24 of Embodiment 4 is exactly the same as the solar cell 23 of Embodiment 3.

Specifically, as shown in FIG. 4, the side faces of the body portion 12 of the solar cell 24 of Embodiment 4 have a shape in which the predetermined side faces 9 that are at least part of the side faces of the body portion 12 extending from the surface of the body portion 12 and include the end faces of the PN junction portion 8 are inclined to taper from the back surface toward the surface of the body portion 12.

The solar cell 24 described above is manufactured as follows. In step 1 of the method for manufacturing the solar cell 23 of Embodiment 3, that is, step 5 of the method for manufacturing the solar cell 21 of Embodiment 1, etching is performed using an aqueous solution of hydrochloric acid and an aqueous solution of ammonia and hydrogen peroxide solution as etching solutions. Other steps are the same as those of the aforementioned method for manufacturing the solar cell 23 of Embodiment 3.

In the solar cell 24 of Embodiment 4 described above, the predetermined side faces 9 that are at least part of the side faces of the body portion 12 extending from the surface of the body portion 12 and include the end faces of the PN junction portion 8 have a shape in which the predetermined side faces 9 are inclined to taper from the back surface toward the surface of the body portion 12. Accordingly, the anti-reflection film 10 can be formed more easily and reliably on the predetermined side faces 9 of the body portion 12 when manufacturing the solar cell 24 as compared to the case where the predetermined side faces 9 do not have that shape.

In the solar cell 24 of Embodiment 4 described above, in the side faces of the body portion 12, the anti-reflection film 10 having an insulating property is formed only on the predetermined side faces 9 that are at least part of the side faces of the body portion 12 extending from the surface of the body portion 12 and include the end faces of the PN junction portion 8 so as to cover the predetermined side faces 9. However, the present embodiment is not limited thereto, and it is also possible to form the anti-reflection film 10 having an insulating property on the entire side faces of the body portion 12 so as to cover the entire side faces.

### <Embodiment 5>

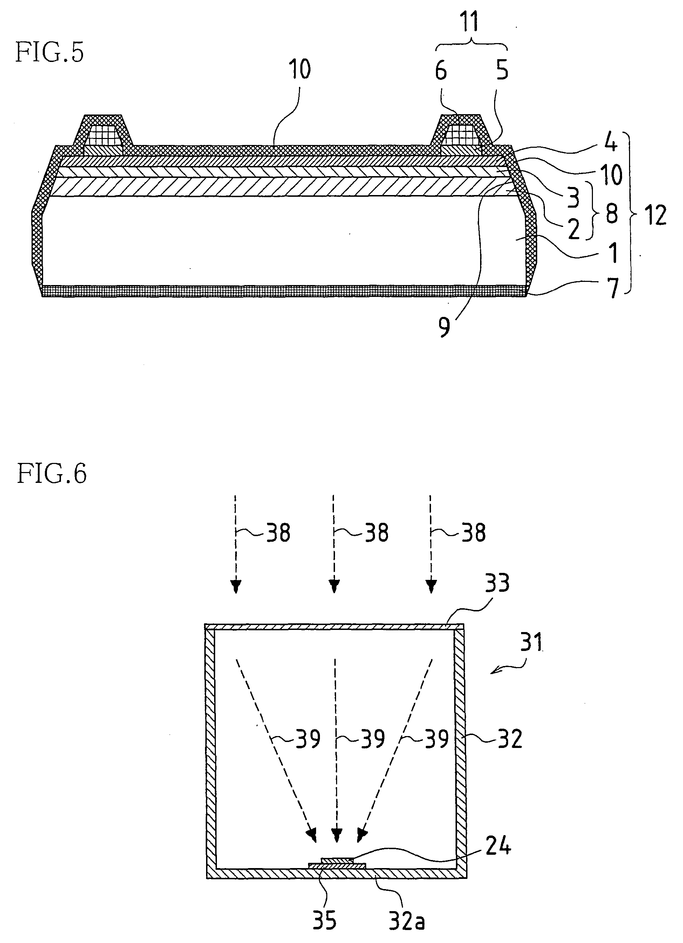

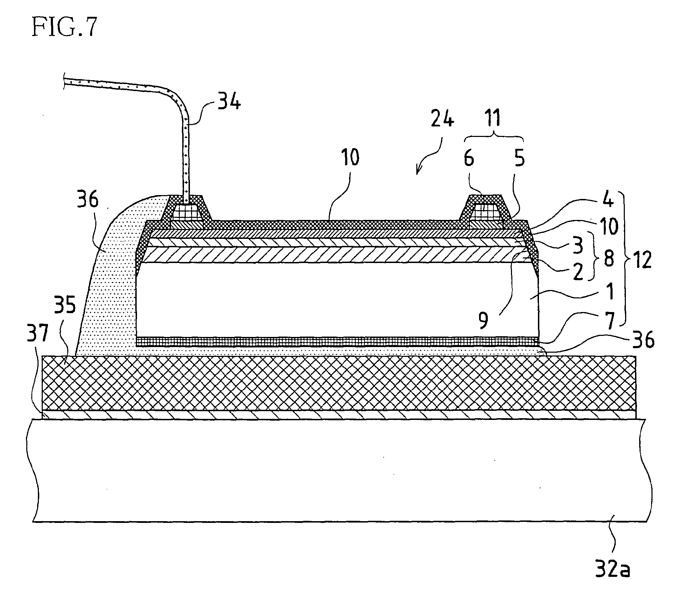

FIG. 6 is a cross-sectional view of a solar cell module 31 that includes the solar cell 24 according to Embodiment 4. FIG. 7 is an enlarged cross-sectional view of an attachment portion of the solar cell 24 of the solar cell module 31. As shown in FIGS. 6 and 7, the solar cell module 31 according to Embodiment 5 is configured of the aforesaid solar cell 24, a case 32, a Fresnel lens 33, a surface electrode connecting lead wire 34, a solar cell holding plate 35, and a back surface electrode connecting lead wire (not shown).

The case 32 is a hollow case that has a rectangular cross section and an opening face at the upper surface. The non-imaging Fresnel lens 33 is attached to the opening face of the case 32. The solar cell holding plate 35 made of metal is fixed on the inner bottom face of the solar cell holding plate support portion 32a serving as the bottom portion of the case 32 with an adhesive 37 having heat conductivity and an insulating property. The solar cell 24 is fixed on the upper surface of the solar cell holding plate 35 with a conductive paste 36 such that the back surface electrode 7 of the solar cell 24 faces the solar cell holding plate 35. The surface electrode connecting lead wire 34 is connected to the surface electrode 6 of a surface electrode portion 11 of the solar cell 24 (specifically, to a terminal attachment portion of the surface electrode portion 6 to which the surface electrode connecting lead wire 34 is bonded by wire-bonding or spot-welding). The back surface electrode connecting lead wire (not shown) is connected to the solar cell holding plate 35.

In the solar cell 24 included in the solar cell module 31, as described above, the anti-reflection film 10 having an insulating property is formed on the surface and side faces of surface electrode portions 11 of the solar cell 24, the surface of the body portion 12 other than the portions where the surface electrode portions 11 are formed, and the predetermined side faces 9 of the body portion 12 so as to cover these faces.

As the material for the case 32, aluminum is suitable because it is lightweight and has good heat conductivity, but it is also possible to use a stainless steel plate, a steel plate, or a steel plate plated with zinc, aluminum, silicon or the like.

As the material for the Fresnel lens 33, a light-transmitting material such as acrylic resin, polycarbonate, UV curable resin or glass is used. The Fresnel lens 33 has a concentration magnification of sunlight of approximately 700 times at the maximum. Sunlight 38 shown by dotted lines in FIG. 6 is concentrated by the Fresnel lens 33 and is irradiated in the form of irradiation light 39 to the solar cell 24 fixed on the upper surface of the solar cell holding plate 35.

As the material for the solar cell holding plate 35, a material containing a metal or alloy having large heat conductivity as a principle material is used. Examples include metal simple substances such as gold, silver, copper, aluminum, magnesium, iron, nickel, tin and stainless steel, and alloys thereof.

As the material for the adhesive 37 having heat conductivity and an insulating property that is used to fix the solar cell holding plate 35 to the solar cell holding plate support portion 32a, a material obtained by mixing, as an additive, at least one selected from metals such as gold, silver, copper, aluminum, magnesium, iron and stainless steel; metal oxides such as aluminum oxide, magnesium oxide and zinc oxide; boron nitride; aluminum nitride; carbon and the like with a base material such as epoxy resin, silicon resin or the like.

As the conductive paste 36 made of a material having large heat conductivity that is used to fix the solar cell element 24 to the solar cell holding plate 35, for example, a material obtained by incorporating at least one selected from metals such as gold, silver, copper, aluminum, magnesium, iron, nickel, tin and stainless steel, and carbon in an organic material or the like, or solder is used. As the fixing method, a method in which the conductive paste 36 is baked, or a method in which the conductive paste 36 is brazed is used.

As the material for the surface electrode connecting lead wire 34, aluminum, gold or the like is used. As the connecting method, wire-bonding is suitable because good conduction between the surface electrode 6 (terminal attachment portion) and the surface electrode connecting lead wire 34 is obtained. Other than the above, it is possible to use a silver foil or the like as the surface electrode connecting lead wire 34, and the silver foil or the like may be spot-welded.

In the solar cell 24 included in the solar cell module 31 according to Embodiment 5, as described above, the anti-reflection film 10 having an insulating property is formed on the surface and side faces of the surface electrode 6 of the surface electrode portions 11 of the solar cell 24, the surface of the body portion 12 other than the portions where the surface electrode portions 11 are formed, and the predetermined side faces 9 of the body portion 12 so as to cover these faces. Accordingly, even if the conductive paste 36 for bonding the solar cell 24 adheres to the surface electrode 6 of the solar cell 24 or a predetermined side face 9 of the body portion 12 when manufacturing the solar cell module 31, it is possible to prevent a leak current from flowing in the solar cell 24 when in use.

A method for manufacturing the solar cell module 31 of Embodiment 5 will be described next. First, the solar cell holding plate 35 is fixed to the solar cell holding plate support portion 32a of the case 32 with the adhesive 37 having heat conductivity and an insulating property. Then, the solar cell 24 is fixed on the upper surface of the fixed solar cell holding plate 35 using the conductive paste 36 having high heat conductivity.

To fix the solar cell 24 to the upper surface of the solar cell holding plate 35, a conductive paste layer made of the conductive paste 36 is first formed between the back surface electrode 7 serving as the back surface of the solar cell 24 and the solar cell holding plate 35. Then, the solar cell 24 is fixed to the solar cell holding plate 35 by pressing the solar cell 24 against the solar cell holding plate 35 such that the back surface electrode 7 of the solar cell 24 comes close to the solar cell holding plate 35 while the conductive paste 36 is allowed to protrude from the conductive paste layer over a predetermined side face 9 of the body portion 12 of the solar cell 24 or the predetermined side face 9 of the body portion 12 of the solar cell 24 and the surface electrode portion 11 of the solar cell 24.

The surface electrode connecting lead wire 34 is then connected to the surface electrode 6 (terminal attachment portion) of the solar cell 24 by wire-bonding or spot-welding. Also, the back surface electrode connecting lead wire is connected to the solar cell holding plate 35. Then, the surface electrode connecting lead wire 34 and the back surface electrode connecting lead wire are pulled out of the case 32. After that, the Fresnel lens 33 is attached to the opening face of the case 32.

The expression "the conductive paste 36 is allowed to protrude" used when describing the method for manufacturing the solar cell module 31 above means that the conductive paste 36 may protrude, and it does not mean that the conductive paste 36 has to protrude.

According to the method for manufacturing the solar cell module 31 described above, in the solar cell 24 used in this manufacturing method, the anti-reflection film 10 having an insulating property is formed on the surface and side faces of the surface electrode portions 11 of the solar cell 24, the surface of the body portion 12 other than the portions where the surface electrode portions 11 are formed, and the predetermined side faces 9 of the body portion 12 so as to cover these faces. Accordingly, even if the conductive paste 36 for bonding the solar cell 24 adheres to a surface electrode portion 11 of the solar cell 24 or the predetermined side face 9 of the body portion 12 when manufacturing the solar cell module 31, it is possible to manufacture the solar cell 24 in which a leak current can be prevented from flowing in the solar cell 24 when in use.

According to the method for manufacturing the solar cell module 31 described above, the surface electrode 6 of the solar cell 24 used in the method for manufacturing the solar cell module 31 is covered with the anti-reflection film 10, but the surface electrode connecting lead wire 34 can be connected to the surface electrode 6 by wire-bonding or spot-welding. Therefore, according to the method for manufacturing the solar cell module 31, it is unnecessary to use a cost and time consuming conventional solar cell that requires the step of exposing the surface electrode that involves a complicated task as described above, and it is thus possible to achieve a reduction in the production cost of the solar cell module 31.

The present invention may be embodied in various other forms without departing from the gist or essential characteristics thereof. Therefore, the embodiments disclosed in this application are to be considered in all respects as illustrative and not limiting. The scope of the invention is indicated by the appended claims rather than by the foregoing description, and all modifications or changes that come within the meaning and range of equivalency of the claims are intended to be embraced therein.

This application claims priority on Japanese Patent Application No. 2006-112409 filed in Japan on April 14, 2006, the entire contents of which are hereby incorporated by reference.

### Industrial Applicability

The present invention is applicable to a solar cell, a solar cell module including the solar cell, and a method for manufacturing the solar cell.

## Claims

1. A solar cell,
wherein a body portion that includes at least one PN junction portion formed by laminating a P layer and an N layer in the front to back direction is formed,
end faces of the PN junction portion form part of side faces of the body portion, and a surface electrode is formed on a surface of the body portion and a back surface electrode is formed on a back surface of the body portion,
the surface electrode includes a terminal attachment portion to which a surface electrode connecting lead wire through which an electromotive force is extracted is bonded by wire-bonding or spot-welding, and
an anti-reflection film is formed on a surface of the surface electrode that includes the terminal attachment portion and the surface of the body portion other than a portion where the surface electrode is formed.

2. The solar cell according to claim 1,
wherein the anti-reflection film is formed on side faces of the surface electrode so as to cover the side faces.

3. The solar cell according to claim 2,
wherein the side faces of the surface electrode are inclined to taper from the surface of the body portion toward the surface of the surface electrode.

4. The solar cell according to claim 1,
wherein the anti-reflection film is formed on predetermined side faces that are at least part of the side faces of the body portion extending from the surface of the body portion and include the end faces of the PN junction portion so as to cover the predetermined side faces.

5. The solar cell according to claim 4,
wherein the predetermined side faces are inclined to taper from the back surface toward the surface of the body portion.

6. A solar cell module comprising:
the solar cell according to any one of claims 1 to 5;
a solar cell holding plate that is made of metal and holds the solar cell; and
the surface electrode connecting lead wire through which an electromotive force is extracted,
wherein the surface electrode connecting lead wire is connected to the terminal attachment portion by wire-bonding or spot-welding,
the anti-reflection film has an insulating property, and at least the surface of the surface electrode other than a portion where the surface electrode connecting lead wire is connected to the surface electrode of the solar cell and the surface of the body portion other than a portion where the surface electrode is formed are covered with the anti-reflection film, and
a conductive paste layer is formed between the back surface electrode of the solar cell and the solar cell holding plate, and the solar cell is held by the solar cell holding plate with the back surface electrode of the solar cell being fixed to the solar cell holding plate by the conductive paste layer.

7. A method for manufacturing the solar cell module according to claim 6 comprising the steps of:
forming the conductive paste layer between the back surface electrode of the solar cell and the solar cell holding plate; and
fixing the solar cell to the solar cell holding plate by pressing the solar cell against the solar cell holding plate such that the back surface electrode of the solar cell comes close to the solar cell holding plate.

8. The method for manufacturing the solar cell module according to claim 7,
wherein the surface electrode connecting lead wire is connected to the surface electrode of the solar cell by wire-bonding or spot-welding.
